# EUROPÄISCHE PATENTSCHRIFT

(11) **EP 3 266 098 B1**
(45) Veröffentlichungstag und Bekanntmachung des Hinweises auf die Patenterteilung: **26.12.2018**
(21) Anmeldenummer: 16705730.6
(22) Anmeldetag: 13.02.2016
(51) Int. Cl.: H02K 9/14, H05K 7/20, F28D 15/02, H01L 23/427

(54) **ANTRIEBSSYSTEM MIT MINDESTENS EINEM WÄRMEROHR UND VERWENDUNG DESSELBEN BEI EINEM ANTRIEBSSYSTEM**
DRIVE SYSTEM COMPRISING AT LEAST ONE HEAT PIPE, AND THE USE OF SAME IN A DRIVE SYSTEM
SYSTÈME D'ENTRAÎNEMENT COMPRENANT AU MOINS UN CALODUC ET UTILISATION DE CELUI-CI AVEC UN SYSTÈME D'ENTRAÎNEMENT

(30) Priorität: 05.03.2015 DE 102015002768
(43) Veröffentlichungstag der Anmeldung: 10.01.2018
(73) Patentinhaber: Amk Arnold Müller GmbH & Co. KG, 73230 Kirchheim/Teck (DE)
(72) Erfinder: MÜLLER, Eberhard, 73230 Kirchheim/Teck (DE); GONSER, Uwe, 73230 Kirchheim/Teck (DE)
(74) Vertreter: Spachmann, Holger
(86) Internationale Anmeldenummer: PCT/EP2016/000247
(87) Internationale Veröffentlichungsnummer: WO 2016/138979

(56) Entgegenhaltungen:
- EP-A1- 2 793 261
- DE-A1- 3 426 581
- DE-A1-102013 210 446
- DE-U1-202013 001 459

## Beschreibung

Die Erfindung betrifft ein Antriebssystem, bestehend aus mindestens einem Antriebsaggregat und mindestens einer zumindest teilweise die Funktion des Antriebsaggregates beeinflussenden Steuereinrichtung, die unter Bildung einer Wärmebrücke mit dem Antriebsaggregat entlang eines Verbindungsbereiches verbunden ist.

Antriebssysteme, insbesondere elektrische Antriebssysteme in der Art von Servomotoren, die auch als handelbare Baueinheit aus Antriebsaggregat und zumindest teilweise die Funktion des Antriebsaggregates beeinflussenden Steuer- und/oder Regelungseinrichtungen bestehen können, sind in mannigfacher Bauart bekannt.

Die DE 10 2006 027 566 A1 beschreibt ein Antriebssystem mit einem als Außenläufermotor gebildeten Antriebsaggregat, wobei die Drehwinkellage des Rotors mittels eines Winkelsensors ermittelt wird. Der Winkelsensor ist Teil einer Steuereinrichtung des Antriebssystems. Antriebssysteme dieser Art werden beispielsweise im Maschinen- und Anlagenbau zu beliebigen Stellzwecken, als Antriebseinheiten an Werkzeugmaschinen, bei Fertigungsstraßen im Automobilbau, in der Textilindustrie oder bei Pressen eingesetzt.

Aus diversen Firmenprospekten der Schutzrechtsinhaberin sind elektrische Servomotoren unterschiedlicher Leistungsklassen und Bauformen für Positionier- und Stellantriebszwecke sowie für den Einsatz als Regelantrieb für kontinuierlichen Lauf vorzugsweise bei niederen und mittleren Drehzahlen bekannt. Die Gehäuse dieser Servomotoren sind mit einer Konvektions- oder Flüssigkeitskühleinrichtung zur Abfuhr von Verlustwärme und zur Erzielung konstanter Betriebsbedingungen der Servomotoren versehen. Ferner sind durch diese Firmenprospekte Servomotoren mit integriertem Servoregler bekannt, die vielseitig einsetzbare, elektronisch unabhängige Antriebsmodule bilden.
Die DE 10 2012 013 447 A1 beschreibt einen Bausatz mit einem vorzugsweise elektrischen Grundmodul, das mit verschiedenen Funktionselementen aus einer Gruppe von Anbaumodulen versehen werden kann.
Als Anbaumodule sind z. B. ein elektrischer Motor oder eine mit einem Kühlfluid, insbesondere einer Kühlflüssigkeit durchströmbare Kühlplatte oder ein zum Übergreifen eines insbesondere elektrischen Motors ausgebildetes Kühlgehäuse, das mit einem gehäuseeigenen Kühlsystem versehen ist, vorgesehen. Durch dergestalt gebildete Bausätze sind anschlußfertige; kompakte Einheiten zum Einbau direkt in Maschinen, auf anzutreibende Wellen oder dergleichen verwirklicht.
Die für solche Antriebssysteme bekannten Fluid-Kühlsysteme lassen inbesondere in Bezug auf ihren Bauraumbedarf, in Bezug auf ihre Ansprüche an die Umgebung des Antriebssystems, wie etwa freie Abströmwege für Kühlluft und dergleichen noch Wünsche offen. DE202013001459U1 beschreibt ein gattungsgemäßes Antriebssystem. Im Hinblick hierauf liegt der Erfindung die Aufgabe zugrunde, ein Antriebssystem anzugeben, das neben einem minimierten Bauraumbedarf eine zumindest annähernd konstante, vorgebbare Betriebstemperatur aufweist.

Diese Aufgabe wird mit einem Antriebssystem mit der Gesamtheit der Merkmale von Patentanspruch 1 gelöst.

Das erfindungsgemäße Antriebssystem zeichnet sich dadurch aus, dass mittels mindestens eines Wärmerohres die im Betrieb des Antriebssystems innerhalb der Wärmebrücke entstehende Abwärme, hervorgerufen durch die jeweilige Betriebstemperatur von Antriebsaggregat und/oder Steuereinrichtung, aus dem Verbindungsbereich von Antriebsaggregat und Steuereinrichtung gezielt abführbar ist. Es ist dadurch ein Antriebssystem geschaffen, bei dem mittels eines vorzugsweise ohne Hilfsenergie arbeitenden Wärmetransportelementes Abwärme sowohl von dem Antriebsaggregat als auch von dessen Steuereinrichtung zeitgleich abführbar ist und dadurch die Betriebstemperatur des Antriebsaggregates und der Steuereinrichtung auf eine vorgebbare Größe einstellbar ist. Dadurch ist ein bauraumsparendes und in seiner Funktion betriebssicher und präzise arbeitendes Antriebssystem geschaffen, dessen Steuereinrichtung wirksam vor schädigenden Betriebstemperaturen des Motors geschützt ist.

Das erfindungsgemäß eingesetzte Wärmerohr ist ein Wärmetransportelement, das einen Verdampfungs-Kondensationsprozeß zum Wärmeabtransport nutzt und im Vergleich zu anderen bekannten Wärmetransport- insbesondere Kühleinrichtungen eine wesentlich höhere Wärmestromdichte verwirklicht. Mit einem Wärmerohr können somit auf kleinen Querschnittsflächen große Wärmemengen transportiert werden.

Bei Wärmerohren unterscheidet man zwischen zwei Hauptbauformen, nämlich der Heatpipe und dem Zwei-Phasen-Thermosiphon. Eine Heatpipe läßt sich als vakuumdicht verschlossenes, evakuiertes System, dessen Innenwände mit einer Kapillarstruktur versehen sind, die mit einem Wärmeträger gesättigt ist, charakterisieren. Führt man dem System an einer Stelle Wärme zu, so dampft der Wärmeträger aus der Kapillarstruktur aus und der Dampf strömt zu einer gekühlten Stelle, kondensiert dort und gibt dabei seine Verdampfungswärme ab. Das Kondensat wird anschließend durch Kapillarkräfte in der Kapillarstruktur zum Ort der Verdampfung zurückgefördert (US 3 229 759 A) und ein neuer Zyklus kann vonstatten gehen, wobei diese Prozesse des Verdampfens und Kondensierens kontinuierlich erfolgen.

Der geschlossene Zweiphasen-Thermosiphon wird auch als schwerkraftunterstütztes Wärmerohr, Gravitations- bzw. Schwerkraftwärmerohr, dochtloses Wärmerohr oder als Wärmerohr ohne Kapillarstruktur bezeichnet. Im Gegensatz zur Heatpipe liegt ein Flüssigkeitssumpf vor. Bei Wärmezufuhr in der Heizzone tritt Behältersieden auf, der Sumpf schäumt auf, Dampf strömt zur Kühlzone und ein Kondensationsfilm fließt aus dieser wieder zurück. In Abhängigkeit von der Art der gewählten Kapillarstruktur kann bei einer Heatpipe ohne Hilfsenergie Kondensat auch gegen die Schwerkraft gefördert werden, sodaß eine Lageunabhängigkeit eines mit einem derartigen Wärmerohr ausgestatten Antriebssystems, bei dessen Einbau ermöglicht ist.

Bei einer besonders bevorzugten Bauform des Antriebssystems ist das jeweilge Wärmerohr zumindest in einen Verdampfer- und einen Kondensatorbereich unterteilt und der Verdampferbereich innerhalb des Verbindungsbereichs und der Kondensatorbereich außerhalb desselben angeordnet. Hierdurch ergibt sich eine im Vergleich zum Einsatz von Wärmerohr-Wärmetauschern mit mehreren Wärmerohren, einfache und kostengünstige Lösung der Regelung einer Betriebstemperatur eines Antriebssystems. Zur Steigerung der Wärmeübertragung des Wärmerohres im Kondensatorbereich kann vorteilhaft ein Wärmetauscher vorgesehen sein, der in wärmeleitendem Kontakt mit dem Kondensatorbereich ist und somit ein weiteres Aggregatteil des Antriebssystems bildet.

Bei einer weiteren vorteilhaften Ausgestaltung des Antriebssystems kann zur Minimierung der Wärmeübertragung von dem Antriebsaggregat auf die Steuereinrichtung über das Wärmerohr, das Wärmerohr mittels einer Wärmeisolierung gegenüber dem Antriebsaggregat thermisch isoliert sein. Das Antriebsaggregat kann mit Hilfe eines flüssigen oder gasförmigen Druckmittels angetrieben sein, bevorzugt ist jedoch das Antriebsaggregat als elektrisch antreibbarer Servo- und/oder Stellmotor in der Art einer Synchron- oder Asynchronmaschine gebildet, der eine entsprechend wärmeempfindliche Leistungselektronik beinhaltet, wobei der an dem Kondensatorbereich des Wärmerohres in wärmeleitendem Kontakt angeordnete Wärmetauscher aus einem plattenförmigen Kühlgrundkörper besteht, von dem fingerartige oder plattenartige Kühlrippen vorstehen, die mit ihrem jeweils freien Ende in die Umgebung des Antriebssystems münden. Durch diese Ausführungsform des Antriebssystems läßt sich eine besonders betriebssichere und effiziente Kühlung der Leistungselektronik und auch des Antriebsaggregates mit einem im Vergleich zum Stand der Technik verringerten Bauraumbedarf des gesamten Antriebssystems verwirklichen.

Aufgrund des vorteilhaften Funktionsprinzips einer Heatpipe ist es möglich, das Wärmerohr bei einem besonders bevorzugten Ausführungsbeispiel etwa rechtwinklig gebogen auszubilden, wobei an der Stelle der Biegung das Wärmerohr aus dem die Wärmebrücke bildenden Verbindungsbereich zwischen Antriebsaggregat und Steuereinrichtung mit seinem Verdampfungsbereich austritt und in einen, eine weitere Wärmebrücke bildenden, weiteren Verbindungsbereich zwischen Antriebsaggregat und Wärmetauscher mit seinem Kondensatorbereich eintritt.

Bei einer bevorzugten Ausführungsform des Antriebsaggregates mündet an der Stelle der zumindest annähernd rechtwinkligen Biegung des Wärmerohres dieses nach außen in die Umgebung und weist nach innen zu einem rückwärtigen Gehäuseabschluss des Antriebsaggregates, dessen vorderer Gehäuseabschluss des Antriebsaggregates von einer Antriebswelle durchgriffen ist. Hierdurch ist ein von der Wärmeabfuhr ungestörter Antrieb von Drittbaukomponenten ermöglicht und das Antriebsaggregat kann ungestört an solchen Drittbaukomponenten, vorzugsweise mit seiner freien Stirnseite, die von der Antriebswelle durchgriffen ist, festgelegt werden.

Um eine besonders an verschiedenste Anbauverhältnisse einer Maschine anpassbares Antriebssystem zur Verfügung zu stellen, ist vorteilhaft die Steuereinrichtung überstandsfrei, vorzugsweise um eine vorgebbare Wegstrecke zurückversetzt, auf einer Gehäuseaußenseite des Antriebsaggregates über Verbindungsstege stationär gehalten, wobei die Verbindungsstege den Verbindungsbereich und zumindest teilweise die eine Wärmebrücke begrenzen. Dergestalt ist auf der Oberseite des Antriebsaggregates eine Wärmeabgabefläche von der Steuereinrichtung freigelassen, die eine konvektive zusätzliche Wärmeabstrahlung ermöglicht.

Um eine besonders effiziente Wärmeabfuhr über einen Wärmetauscher zu erreichen, ist vorteilhaft dieser Wärmetauscher vollflächig an dem rückwärtigen Gehäuseabschluß des Antriebsaggregates angeordnet und deckt diesen vorzugsweise vollständig ab. Der Wärmetauscher kann mittels weiterer Verbindungsstege unter Bildung eines weiteren Verbindungsbereiches an einer vorzugsweise eine weitere Wärmeableitung ermöglichenden Verbindungsfläche eines Maschinengehäuses oder dergleichen stationär gehalten sein.

Um eine gute Wärmeleitung von dem Antriebsaggregat zu dem Wärmerohr zu ermöglichen, ist bei einem besonders bevorzugten Ausführungsbeispiel zumindest ein Teil des Gehäuses des Antriebsaggregates aus einem im Druckgussverfahren oder aus einem mittels eines Strangzieh- oder - gussverfahrens hergestellten Korpus gebildet, wobei Aluminium oder Zink als Gehäusematerialen verwendet sind.

Die Erfindung sieht ferner eine Verwendung eines Wärmerohres bei einem erfindungsgemäßen Antriebssystem zum Schutz der Steuereinrichtung mit ihrer wärmeempfindlichen Leistungselektronik gegenüber der die Leistungselektronik nachteilig beeinflussenden, gegebenenfalls schädigenden Betriebstemperatur des Antriebsaggregates vor.

Weitere Vorteile und Merkmale der Erfindung ergeben sich aus den Figuren und der nachfolgenden Beschreibung der Zeichnung. Es zeigen in schematischer und nicht maßstäblicher Darstellung die
- Fig. 1: eine perspektivische Ansicht auf ein erfindungsgemäßes Antriebssystem;
- Fig. 2: eine Seitenansicht auf das Antriebssystem nach der Fig. 1, mit teilweiser Schnittdarstellung betreffend eine Wärmerohrführung als Wärmekompensationsmittel.

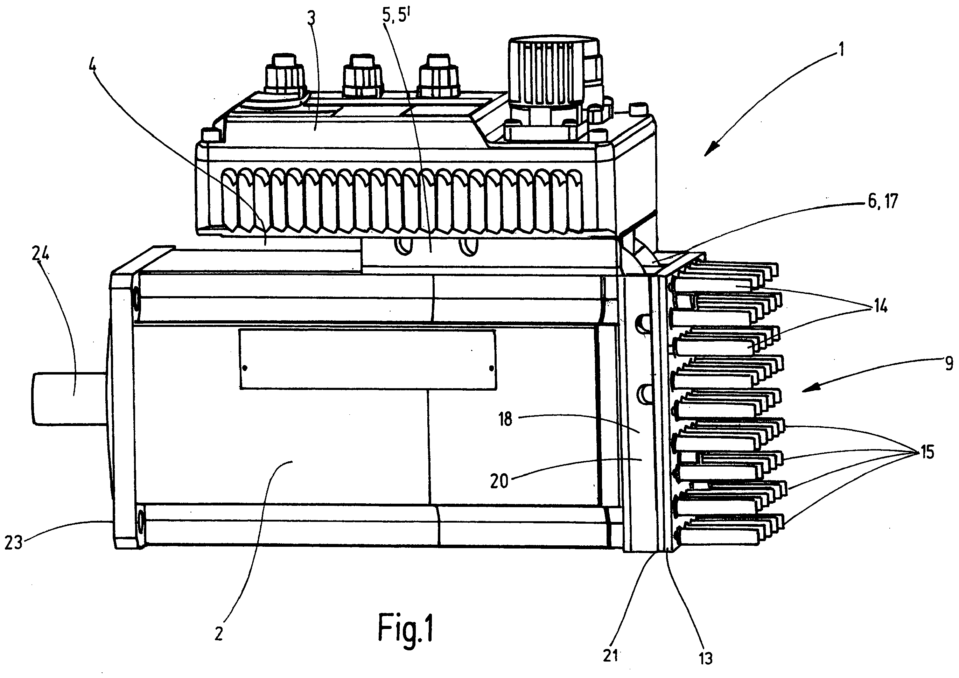

Fig. 1 zeigt eine perspektivische Ansicht auf das erfindungsgemäße Antriebssystems 1 als Ganzes, im Wesentlichen bestehend aus einem Antriebsaggregat 2 in der Art eines elektrischen Servomotors, regelmäßig vorgesehen zu Positionier- und Stellzwecken von Drittbaukomponenten (nicht dargestellt) und einer das Antriebsaggregat 2 zumindest teilweise steuernden Steuereinrichtung 3, vorzugsweise in der Art einer Hochleistungselektronik ausgebildet. Das Antriebssystem 1 ist auch für eine Anwendung bei problematischer Kühlsituation, bedingt beispielsweise durch eine hohe Integrationsdichte von Systemkomponenten am Einsatzort oder einer dort herrschenden hohen Umgebungstemperatur, ausgelegt.

Die in dem gezeigten Ausführungsbeispiel an einer Oberseite des Antriebsaggregates 2 und aus Platzersparnisgründen mit geringstmöglichem Abstand zu diesem Aggregat 2 angeordnete Steuereinrichtung 3 ist unter Bildung einer Wärmebrücke 4 mit dem Antriebsaggregat 2 entlang eines Verbindungsbereiches 5 verbunden. Der Verbindungsbereich 5 erstreckt sich über eine Teillänge, vorzugsweise etwa über die halbe Länge des Antriebsaggregates 2 in axialer Richtung gesehen und ist demgemäß kürzer ausgebildet als der die Wärmebrücke bildende Wärmeübergangsbereich zwischen Aggregat 2 und Steuereinrichtung 3. Zur Verbindung der beiden genannten Komponenten des Antriebssystems 2 miteinander ist mindestens eine im Querschnitt gesehen U- oder L-förmig geformte Schiene 5' vorgesehen, die bevorzugt aus einem Werkstoff mit geringer Wärmeleitfähigkeit, gebildet ist, wobei die Steuereinrichtung 3 über den Schienenverbindungsbereich lösbar, aber ansonsten stationär mit dem Antriebsaggregat 2 verbunden ist. Vorzugsweise ist jedoch ein Paar von parallel zueinander verlaufenden Schienen 5' vorhanden, um die Steuereinrichtung 3 auf dem Aggregat 2 aufzuständern.

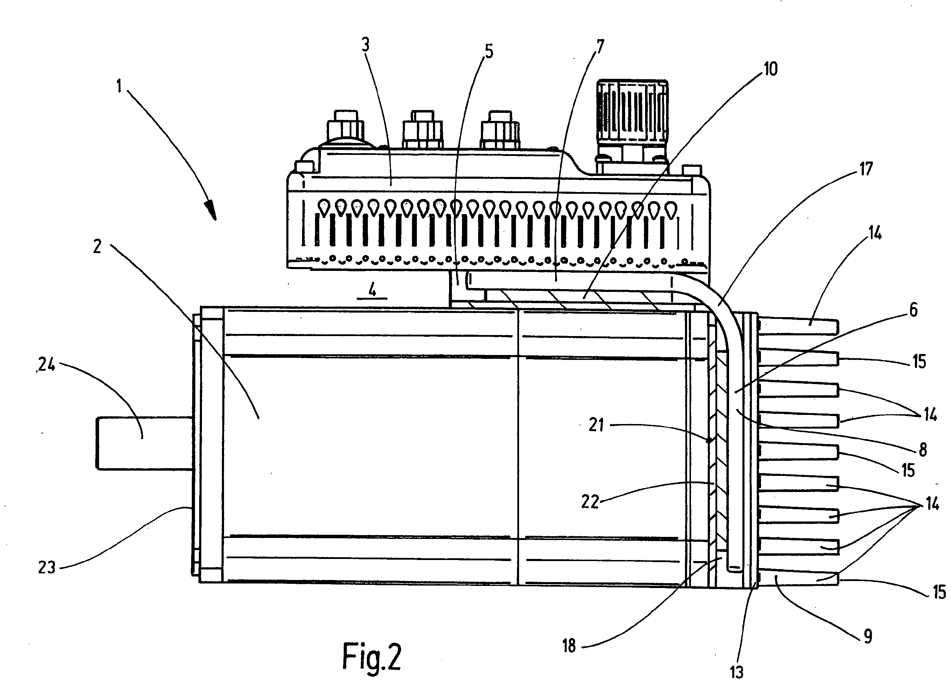

Das Antriebssystem 1 weist erfindungsgemäß zwischen der Steuereinrichtung 3 und dem Antriebsaggregat 2 ein Wärmerohr 6 in der Art einer Heatpipe auf, das sich, wie insbesondere Fig. 2 zeigt, entlang des Verbindungsbereiches 5 mit seinem Verdampfungsbereich 7 erstreckt. Das Wärmerohr 6 ist in einem freien, kanalartigen Querschnitt, der durch die jeweilige Festlegeschiene 5' definiert ist, angeordnet und vor mechanischen Beschädigungen bei der Montage und im Betrieb des Antriebssystems 1 geschützt. Mit Hilfe des Wärmerohres 6 ist das innerhalb der Wärmebrücke 4 entstehende Wärmeaufkommen, insbesondere Abwärme, hervorgerufen durch die jeweilige Betriebstemperatur des Antriebsaggregats 2, aus dem Verbindungsbereich 5 abführbar, wobei durch die gewählten technischen Parameter des Wärmerohres 6 und die physikalischen Stoffkennwerte des in dem Wärmerohr 6 eingeschlossenen Wärmeträgerfluids ein konstant Niedrighalten der Betriebstemperatur der Steuereinrichtung 3 ermöglicht ist, und zwar unabhängig von der zeitlich variierenden Leistungsabgabe des Antriebsaggregates 2. So kann das Aggregat 2 durchaus im Betrieb eine über sein Gehäuse abgestrahlte Temperatur von 150 °C und mehr erreichen, die ohne die erfindungsgemäße Wäremrohr-Temperaturableitung die temperaturempfindliche Steuer-, insbesondere Hochleistungselektronik der Steuereinrichtung 3 schädigen würde, die regelmäßig für einen störungsfreien Betrieb einer Maximaltemperatur von 70 °C ausgesetzt werden darf.

Das für den dahingehenden Wärmeabtransport vorgesehene Wärmerohr 6 ist ein vakuumdicht verschlossenes, evakuiertes System, dessen Innenwände mit einer Kapillarstruktur versehen sind, die mit einem Wärmeträgerfluid gesättigt ist. Das Wärmerohr 6 arbeitet dabei ohne Zufuhr von Antriebsenergie, außer der durch die von außen zugeführten Wärme, die überwiegend vom Antriebsaggregat 2 stammt. Jedoch kann bei reduzierter Motorleistung oder abgestelltem Antriebsaggregat 2 etwaig überschüssige Wärmemengen im Bereich der Wärmebrücke 4 über das jeweilige Wärmerohr 6 gleichfalls abgeführt werden, die auch von der sich abkühlenden Steuereinrichtung 3 stammen können.

Wie die Fig. 2 zeigt, ist das Wärmerohr 6 in den Verdampfungsbereich 7 und einen sich daran einstückig anschließenden Kondensatorbereich 8 unterteilt, wobei der Verdampfungsbereich 7, wie erwähnt, innerhalb des Verbindungsbereiches 5 und der Kondensatorbereich 8 außerhalb dieses Verbindungsbereiches 5 angeordnet ist. Die an dem Verdampfungsbereich 7 anstehende Wärme, die überwiegend durch die Verlustleistungen des Antriebsaggregates 2 im Betrieb entsteht, führt zu einem Verdampfen des Wärmeträgerfluids aus der Kapillarstruktur des Verdampfungsbereiches 7 des Wärmerohres 6, wobei der Dampf im Inneren des Wärmerohres 6 zu dem Kondensatorbereich 8 strömt. Der Kondensatorbereich 8 des Wärmerohres 6 ist dabei bevorzugt in einem wärmeleitenden, insbesondere wärmeabführenden, Kontakt mit einem Wärmetauscher 9, der Bestandteil des Antriebssystems 1 ist und dessen Aufbau und Funktion im folgendem noch näher beschrieben wird.

Um zusätzlich eine schädigende Wärmeübertragung von dem Antriebsaggregat 2 zu der Steuereinrichtung 3 über den Verbindungsbereich 5 als Teil der Wärmebrücke 4 zu verhindern, ist eine Wärmeisolierung 10 vorhanden, beispielsweise aus einem hitzebeständigen Plattenmaterial gebildet, die auf Abstand gehalten parallel zum Wärmerohr 6 auf der Oberseite des Aggregates 2 und in Anlage mit demselben verläuft. Aufgrund des Abstandes ist eine Art Luftspalt gebildet, der schlecht die Wärme überträgt, so dass neben dem Wärmerohr 6 eine weitere Wärmeentkopplung von Aggregat 2 zu Steuereinrichtung 3 geschaffen ist. Das Antriebsaggregat 2 ist als Servomotor in der Art einer elektrisch antreibbaren Synchronmaschine und die Steuereinrichtung 3 beispielsweise in der Art eines integrierten Servoreglers ausgebildet, der unter anderem zur Steuerung der Drehrichtung, der Drehzahl und eines Haltemomentes des Antriebsaggregates 2 die Leistungselektronik 13 beinhaltet, die bekanntermaßen im Betrieb gleichfalls Verlustwärme erzeugt, die abzuführen ist, wozu das Wärmerohr 6 unter anderem mit herangezogen werden kann.

Der Wärmetauscher 9 besteht aus einem vollflächigen, plattenartigen Kühlgrundkörper 13 von dem senkrecht Kühlrippen 14 vorstehen, die mit ihrem jeweiligen freien Ende 15 in die Umgebung des Antriebssystems 1 ragen, und die in dem gezeigten Ausführungsbeispiel fingerartig ausgebildet sind, aber auch plattenartig oder in anderer geeigneter Bauform ausgebildet sein können. Die Kühlrippen 14 weisen etwa die fünf- bis zehnfache Länge bezogen auf die Dicke des plattenförmigen Kühlgrundkörpers 13 auf.

Um das Antriebsaggregat 2 besonders kompakt zu gestalten, ist das Wärmerohr 6 rechtwinklig gebogen. Es weist mithin an seinem Übergangsbereich zwischen Verdampfungsbereich 7 und Kondensatorbereich 8 eine Biegung 17 auf, an der es mit seinem Verdampfungsbereich 7 austritt und in einen, eine weitere Wärmebrücke 18 bildenden Verbindungsbereich 19 zwischen Wärmerohr 6 und Wärmetauscher 9 mit seinem Kondensatorbereich 8 eintritt. Somit ist im Wesentlichen der gesamte Kondensatorbereich 8 des Wärmerohres 6 an dem Wärmetauscher 9 im Bereich seines Kühlgrundkörpers 13 anliegend angeordnet und im Übrigen durch die Biegung 17 und die damit in Verbindung stehende Wärmerohrführung eine wirksame räumliche Entkoppelung zwischen wärmeaufnehmendem Verdampferbereich 7 und wärmeabgebenden Kondensatorbereich 8 verwirklicht, die einen störungsfreien und effizienten Betrieb ermöglicht.

Der Wärmetauscher 9 ist wiederum über paarweise einander gegenüberliegende Schienenstücke 20 vergleichbar aufgebaut wie die Schienen 5', mit der Rückwand des Antriebsaggregates 2 als rückwärtigem Gehäuseabschluss 21 verbunden, die den weiteren zweiten Verbindungsbereich 19 von seiner räumlichen Ausgestaltung mit definieren, in den der Kondensatorbereich 8 des Wärmerohres 6 eintaucht, das mit seinem unteren freien Ende im Wesentlichen bündig mit der gemeinsamen Unterseite von Antriebsaggregat 2 und Wärmetauscher 9 abschließt. Auch ist wiederum bevorzugt für eine Wärmeentkoppelung zwischen dem Kondensatorbereich 8 des Wärmerohres 6 und dem Gehäuseabschluss 21 eine weitere plattenförmige Wärmeisolierung 22 angebracht, die sich im Wesentlichen entlang des rückseitigen Gehäuseabschlusses 21 erstreckt.

An der Stelle der Biegung 17 des Wärmerohres 6 mündet dieses nach außen in die Umgebung und weist mit seinem Verlauf nach innen zu dem rückwärtigen Gehäuseabschluß 21 des Antriebsaggregates 2 hin. Der vordere, gegenüberliegende Gehäuseabschluß 23 ist von einer Antriebswelle 24 des Servomotors durchgriffen.

Zur besseren Wärmeleitung ist zumindest ein Teil des Umgebungsgehäuses des Antriebsaggregates 2 aus einem im Druckgußverfahren hergestellten Korpus gebildet oder aus einem Stranggußprofil hergestellt, wobei Aluminium oder Zink als Gehäusematerialen bevorzugt verwendet werden.

Durch die Verwendung eines Wärmerohres 6 kann der Wärmetransport bezogen auf die Wärmemenge und Geschwindigkeit der Wärmeleitung im Vergleich zu einem massiven Kupferleiter um das 100- bis 1 000-fache gesteigert werden. Wärmerohre 6 sind auch bei kleinsten Abmessungen (Durchmesser ca. 10 bis 500 mm) voll funktionsfähig, wodurch ein vorteilhaftes Antriebssystem 1 erhalten ist, das sowohl von der Steuereinrichtung 3 als auch von dem Antriebsaggregat 2 stammende, die Funktionssicherheit beeinträchtigende Wärme ableiten kann, wobei dennoch eine kompakte Bauweise des Antriebssystems 1 erreicht ist. Im Bedarfsfall können auch mehrere Wärmerohre 6 in Neben- oder Hintereinanderanordnung (nicht dargestellt) eingesetzt werden.

Insbesondere ist mit dem erfindungsgemäßen Antriebssystem 1 ein Anbaumodel verwirklicht, das im Bedarfsfall sich nahezu beliebig an anzutreibenden Drittbaukomponenten festlegen lässt. Durch die wärmeentkoppelte Bauweise lässt sich die Steuerintelligenz dezentral mit dem Antriebsaggregat 2 vor Ort kombinieren und man braucht nicht mehr von einer zentralen Warte aus, regelmäßig in Form eines Schaltschrankes in der die Steuereinrichtungen aufgenommen sind, zentral über eine aufwändig zu realisierende Verdrahtung die Ansteuerung und den Betrieb des an einer Maschine jeweils zum Einsatz kommenden Antriebsaggregates 2 vorzunehmen. Dies hat so keine Entsprechung im Stand der Technik.

## Patentansprüche

1. Antriebssystem (1), bestehend aus mindestens einem Antriebsaggregat (2) und mindestens einer zumindest teilweise die Funktion des Antriebsaggregates (2) beeinflussenden Steuereinrichtung (3), die unter Bildung einer Wärmebrücke (4) mit dem Antriebsaggregat (2) entlang eines Verbindungsbereiches (5) verbunden ist, umfassend mindestens ein Wärmerohr (6), um die im Betrieb des Systems (1) innerhalb der Wärmebrücke (4) entstehende Abwärme, hervorgerufen durch die jeweilige Betriebstemperatur von Antriebsaggregat (2) und Steuereinrichtung (3), aus dem Verbindungsbereich (5) abzuführen, **dadurch gekennzeichnet, dass** das Wärmerohr (6) zumindest in einen Verdampfer (7)- und einen Kondensatorbereich (8) unterteilt ist, der Verdampferbereich (7) innerhalb des Verbindungsbereiches (5) und der Kondensatorbereich (8) außerhalb desselben angeordnet ist, und der Kondensatorbereich (8) des Wärmerohres (6) im wärmeleitenden Kontakt mit mindestens einem Wärmetauscher (9) ist, der als weiteres Aggregatteil Bestandteil des Antriebssystems (1) ist.

2. Antriebssystem nach einem der vorstehenden Ansprüche, **dadurch gekennzeichnet, dass** zumindest ein Wärmerohr (6) mittels einer Wärmeisolierung (10) zumindest gegenüber dem Antriebsaggregat (2) separiert ist.

3. Antriebssystem nach einem der vorstehenden Ansprüche, **dadurch gekennzeichnet, dass**
- das Antriebsaggregat (2) ein elektrisch antreibbarer Servo- und/oder Stellmotor ist,
- die Steuereinrichtung (3) eine wärmeempfindliche Leistungselektronik beinhaltet, und
- der Wärmetauscher (9) aus einem plattenförmigen Kühlgrundkörper (13) besteht, von dem fingerartige Kühlrippen (14) vorstehen, die mit ihrem jeweils freien Ende (15) in die Umgebung münden.

4. Antriebssystem nach einem der vorstehenden Ansprüche, **dadurch gekennzeichnet, dass** zumindest ein Wärmerohr (6) rechtwinklig gebogen ist und an der Stelle der Biegung (17) aus dem die Wärmebrücke (4) bildenden Verbindungsbereich (5) zwischen Antriebsaggregat (2) und Steuereinrichtung (3) mit seinem Verdampferbereich (7) austritt und in einen, eine weitere Wärmebrücke (18) bildenden, weiteren Verbindungsbereich (19) zwischen Antriebsaggregat (22) und Wärmetauscher (9) mit seinem Kondensatorbereich (8) eintritt.

5. Antriebssystem nach einem der vorstehenden Ansprüche, **dadurch gekennzeichnet, dass** an der Stelle der Biegung (17) des Wärmerohres (6) dieses nach außen in die Umgebung mündet und nach innen zum rückwärtigen Gehäuseabschluss (21) des Antriebsaggregates (2) weist, dessen vorderer Gehäuseabschluss (23) von einer Antriebswelle (24) durchgriffen ist.

6. Antriebssystem nach einem der vorstehenden Ansprüche, **dadurch gekennzeichnet, dass** die Steuereinrichtung (3) überstandsfrei, vorzugsweise um eine vorgebbare Wegstrecke zurückversetzt, auf einer Gehäuseaußenseite des Antriebsaggregates (2) über Verbindungsstege (5') stationär gehalten ist, die den Verbindungsbereich (5) und zumindest teilweise die eine Wärmebrücke (4) begrenzen.

7. Antriebssystem nach einem der vorstehenden Ansprüche, **dadurch gekennzeichnet, dass** der Wärmetauscher (9) vollflächig den rückwärtigen Gehäuseabschluss (21) des Antriebsaggregates (2) abdeckt und dort mittels weiterer Verbindungsstege (20) stationär gehalten ist.

8. Antriebssystem nach einem der vorstehenden Ansprüche, **dadurch gekennzeichnet, dass** zumindest ein Teil des Gehäuses des Antriebsaggregates (2) aus mindestens einem im Druckgussverfahren hergestellten Korpus besteht oder aus einem Stranggussprofil hergestellt ist und dass bevorzugt Aluminium oder Zink als Gehäusematerialien verwendet sind.

9. Antriebssystem nach einem der vorstehenden Ansprüche, **dadurch gekennzeichnet, dass** das Wärmerohr (6) als Heatpipe konzipiert ist.

10. Verwendung mindestens eines Wärmerohres (6) bei einem Antriebssystem (1) nach einem der vorstehenden Ansprüche zum Schutz der Steuereinrichtung (3) mit ihrer wärmeempfindlichen Leistungselektronik gegenüber der die Leistungselektronik nachteilig beeinflussenden, gegebenenfalls schädigenden Betriebstemperatur des Antriebsaggregates (2).

## Claims

1. Drive system (1), consisting of at least one drive unit (2) and at least one control device (3) at least partially influencing the operation of the drive unit (2), which is connected to the drive unit (2) along a connection area (5) to form a thermal bridge (4), comprising at least one heat pipe (6) to remove the waste heat generated during operation of the system (1) inside the thermal bridge (4) and caused by the respective operating temperatures of the drive unit (2) and/or the control device (3), **characterised in that** the heat pipe (6) is split at least into an evaporator area (7) and a condenser area (8), and the evaporator area (7) is arranged inside the connection area (5) and the condenser area (8) outside the latter, and the condenser area (8) of the heat pipe (6) is in heat-conducting contact with at least one heat exchanger (9) which as a further unit part is an integral part of the drive system (1).

2. Drive system according to one of the preceding claims, **characterised in that** at least one heat pipe (6) is separated by means of a thermal insulation (10) at least from the drive unit (2).

3. Drive system according to one of the preceding claims, **characterised in that**
- the drive unit (2) is an electrically drivable servo and/or actuator motor,
- the control device (3) contains a heat-sensitive power electronic unit, and
- the heat exchanger (9) consists of a plate-like basic cooling element (13), from which protrude finger-like cooling fins (14) which each lead with their free ends (15) into the surroundings.

4. Drive system according to one of the preceding claims, **characterised in that** at least one heat pipe (6) is bent at a right angle and at the location of the bend (17) exits with its evaporator area (7) the connection area (5) forming the thermal bridge (4) between drive unit (2) and control device (3) and enters with its condenser area (8) a further connection area (19) forming a further thermal bridge (18) between drive unit (22) and heat exchanger (9).

5. Drive system according to one of the preceding claims, **characterised in that** at the location of the bend (17) of the heat pipe (6) the latter leads outwards into the surroundings and faces inwards a rear housing face (21) of the drive unit (2), whose front housing face (23) is passed through by a drive shaft (24).

6. Drive system according to one of the preceding claims, **characterised in that** the control device (3) is mounted stationary, without projecting, preferably recessed by a preselectable distance, on an outer housing side of the drive unit (2) by connection webs (5') which limit the connection area (5) and at least partially the thermal bridge (4).

7. Drive system according to one of the preceding claims, **characterised in that** the heat exchanger (9) completely covers the rear housing face (21) of the drive unit (2) and is mounted stationary there by means of further connection webs (20).

8. Drive system according to one of the preceding claims, **characterised in that** at least part of the housing of the drive unit (2) consists of at least one element manufactured in a die-casting process or is manufactured from an extruded section, and **in that** aluminium or zinc are preferably used as housing materials.

9. Drive system according to one of the preceding claims, **characterised in that** the heat pipe (6) is designed as a heat pipe.

10. Use of at least one heat pipe (6) in a drive system (1) according to one of the preceding claims for protecting the control device (3) with its heat-sensitive power electronic unit from the operating temperature of the drive unit (2) having a detrimental and possibly damaging effect on the power electronic unit.

## Revendications

1. Système d'entraînement (1) composé d'au moins une unité d'entraînement (2) et d'au moins un dispositif de commande (3) influençant au moins partiellement la fonction de ladite unité d'entraînement (2), ledit dispositif de commande étant relié à l'unité d'entraînement (2) le long d'une zone de liaison (5), en formant un pont thermique (4), comprenant au moins un tube caloporteur (6) pour évacuer hors de ladite zone de liaison (5) la chaleur dégagée causée par les températures de service respectives de l'unité d'entraînement (2) et du dispositif de commande (3) et produite à l'intérieur du pont thermique (4) lors du fonctionnement du système (1), **caractérisé en ce que** ledit tube caloporteur (6) est divisé au moins en une zone d'évaporation (7) et une zone de condensation (8), que la zone d'évaporation (7) est disposée à l'intérieur de la zone de liaison (5) et la zone de condensation (8) est disposée à l'extérieur de ladite zone de liaison, et que la zone de condensation (8) du tube caloporteur (6) est en contact thermoconducteur avec au moins un échangeur thermique (9) qui fait partie du système d'entraînement (1) en tant que composant supplémentaire.

2. Système d'entraînement selon une des revendications précédentes, **caractérisé en ce qu'**au moins un tube caloporteur (6) est séparé au moins de l'unité d'entraînement (2) au moyen d'une isolation thermique (10).

3. Système d'entraînement selon une des revendications précédentes, **caractérisé en ce que**
- l'unité d'entraînement (2) est un servomoteur et/ou un moteur de commande pouvant être entraîné électriquement,
- le dispositif de commande (3) contient une électronique de puissance sensible à la chaleur, et que
- l'échangeur thermique (9) est constitué d'un refroidisseur de base (13) en forme de plaques duquel dépassent des ailettes de refroidissement (14) en forme de doigts dont les extrémités libres (15) respectives débouchent dans l'environnement.

4. Système d'entraînement selon une des revendications précédentes, **caractérisé en ce qu'**au moins un tube caloporteur (6) est coudé à angle droit et dont la zone d'évaporation (7) sort de la zone de liaison (5) entre l'unité d'entraînement (2) et le dispositif de commande (3), formant le pont thermique (4), au niveau de la courbure (17), et dont la zone de condensation (8) entre dans une autre zone de liaison (19) entre l'unité d'entraînement (22) et l'échangeur thermique (9), formant un autre pont thermique (18).

5. Système d'entraînement selon une des revendications précédentes, **caractérisé en ce qu'**au niveau de la courbure (17) du tube caloporteur (6), celui-ci débouche vers l'extérieur dans l'environnement et est dirigé vers l'intérieur vers la bordure arrière du boîtier (21) de l'unité d'entraînement (2) dont la bordure avant du boîtier (23) est transpercée par un arbre d'entraînement (24).

6. Système d'entraînement selon une des revendications précédentes, **caractérisé en ce que** le dispositif de commande (3) est maintenu de manière fixe, sans saillie, décalé d'une voie prédéterminable, sur un côté extérieur du boîtier de l'unité d'entraînement (2) par des nervures de liaison (5') qui délimitent la zone de liaison (5) et au moins partiellement ledit au moins un pont thermique (4).

7. Système d'entraînement selon une des revendications précédentes, **caractérisé en ce que** l'échangeur thermique (9) recouvre sur toute sa surface la bordure arrière du boîtier (21) de l'unité d'entraînement (2) et y est maintenu de manière fixe au moyen d'autres nervures de liaison (20).

8. Système d'entraînement selon une des revendications précédentes, **caractérisé en ce qu'**au moins une partie du boîtier de l'unité d'entraînement (2) est constituée d'au moins un corps fabriqué par procédé de moulage par pression ou à partir d'un profil en coulée continue et que, de préférence, de l'aluminium ou du zinc sont utilisés comme matériaux pour le boîtier.

9. Système d'entraînement selon une des revendications précédentes, **caractérisé en ce que** le tube caloporteur (6) est conçu sous forme de caloduc (heatpipe).

10. Utilisation d'au moins un tube caloporteur (6) pour un système d'entraînement (1) selon une des revendications précédentes pour protéger le dispositif de commande (3) avec son électronique de puissance sensible à la chaleur, de la température de service de l'unité d'entraînement (2) ayant un impact néfaste sur l'électronique de puissance, voire l'endommageant.
